# EUROPEAN PATENT APPLICATION

(11) **EP 4 447 109 A1**
(43) Date of publication of application: **16.10.2024**
(21) Application number: 22903854.2
(22) Date of filing: 13.10.2022
(51) Int. Cl.: H01L 25/065, H01L 23/12, H01L 25/07, H01L 25/18

(54) **SEMICONDUCTOR DEVICE**

(30) Priority: 08.12.2021 JP 2021199534
(71) Applicant: Sony Semiconductor Solutions Corporation, Atsugi-shi, Kanagawa 243-0014 (JP)
(72) Inventor: SHIGETOSHI, Takushi, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/038218
(87) International publication number: WO 2023/105920

(57) **Abstract**

Uneven warpage in a semiconductor device is corrected. A semiconductor device includes a semiconductor substrate, a recessed portion layer, and a filling film. A semiconductor element is formed on the semiconductor substrate. The recessed portion layer includes recessed portions that have openings in the same surface other than a formation surface of the semiconductor element and that are unevenly arranged. The filling film fills the recessed portions. The recessed portions may be different in at least one of a density, a width, a depth, and a shape in the recessed portion layer according to at least one of a position of a sub-substrate which is mounted on the semiconductor substrate, a wire density of a wire which is formed in the semiconductor substrate, and an arrangement density of a through electrode which is formed in the semiconductor substrate.

## Description

### [Technical Field]

The present technology relates to a semiconductor device. More specifically, the present technology relates to a semiconductor device in which uneven warpage can be corrected.

### [Background Art]

In a semiconductor substrate on which a semiconductor element is formed, warpage occurs in some cases. When warpage of a semiconductor substrate occurs, a manufacturing defect or a mounting defect occurs, and deterioration in reliability is caused. In order to reduce such warpage of a semiconductor substrate, for example, a configuration in which a lattice-shaped slits are formed in a rear surface of the semiconductor substrate and the slits are filled with resin has been disclosed (see PTL 1, for example).

### [Citation List]

### [Patent Literature]

[PTL 1]
Japanese Patent Laid-Open No. 2004-186651

### [Summary]

### [Technical Problem]

However, according to the above conventional technology, lattice-shaped slits having the uniform width and depth are evenly disposed on a rear surface of a semiconductor substrate. Therefore, only even warpage of the semiconductor substrate can be corrected, and uneven warpage of the semiconductor substrate cannot be corrected.

The present technology has been achieved in view of such a circumstance, and an object thereof is to correct uneven warpage in a semiconductor device.

### [Solution to Problem]

The present technology has been achieved in order to solve the above-described problem. A first aspect of the present technology is a semiconductor device including a semiconductor substrate on which a semiconductor element is formed, a recessed portion layer including recessed portions that have openings in the same surface other than a formation surface of the semiconductor element and that are unevenly arranged, and a filling film that fills the recessed portions. This provides an effect of correcting uneven warpage of the semiconductor substrate.

In addition, according to the first aspect, the filling film may be an inorganic film or a resin film. This provides an effect of correcting uneven warpage of the semiconductor substrate.

Moreover, according to the first aspect, the recessed portions may be grooves or holes. This provides an effect of setting a distribution of the recessed portions so as to correct uneven warpage of the semiconductor substrate.

Further, according to the first aspect, the recessed portions may be different in at least one of a density, a width, a depth, and a shape in the recessed portion layer. This provides an effect of setting a distribution of the recessed portions so as to correct uneven warpage of the semiconductor substrate.

In addition, according to the first aspect, the recessed portions may be different in at least one of the density, the width, the depth, and the shape in the recessed portion layer, according to at least one of a position of a sub-substrate which is mounted on the semiconductor substrate, a wire density of a wire which is formed in the semiconductor substrate, and an arrangement density of a through electrode which is formed in the semiconductor substrate. This provides an effect of setting a distribution of the recessed portions so as to correct uneven warpage of the semiconductor substrate while taking the arrangement condition of the sub-substrate mounted on the semiconductor substrate or the wire and the through electrode formed in the semiconductor substrate into consideration.

Moreover, according to the first aspect, the recessed portions may be formed in a lattice-like pattern, a circular pattern, or an isolated pattern. This provides an effect of setting a distribution of the recessed portions so as to correct uneven warpage of the semiconductor substrate while suppressing occurrence of a crack.

Further, according to the first aspect, the recessed portion layer may be formed on a surface of the semiconductor substrate opposite to the surface on which the semiconductor element is formed. This provides an effect of correcting uneven warpage of the semiconductor substrate without reducing the occupation area of the semiconductor element formed on the semiconductor substrate.

The semiconductor device may further include a protective film that is formed on the semiconductor substrate, and the recessed portion layer may be formed in the protective film. This provides an effect of correcting uneven warpage of the semiconductor substrate without causing a problem in drawing a wire from a rear surface of the semiconductor substrate.

In addition, according to the first aspect, the semiconductor device may further include a support substrate that supports the semiconductor substrate, and the recessed portion layer may be formed in the support substrate. This provides an effect of correcting uneven warpage of the semiconductor substrate while achieving the thin semiconductor substrate.

Moreover, according to the first aspect, each of the recessed portions may have a width that is greater than 0 µm but is equal to or less than 10 µm, and may have a depth that is greater than 0 µm but is equal to or less than 30 µm. This provides an effect of finely setting a distribution of the recessed portions so as to correct uneven warpage of the semiconductor substrate.

Further, according to the first aspect, the recessed portions may be separated from an end of the semiconductor substrate. This provides an effect of suppressing occurrence of a crack starting from the recessed portion.

In addition, according to the first aspect, the semiconductor device may further include a rear-surface wire that is formed on the surface of the semiconductor substrate opposite to the surface on which the semiconductor element is formed, and the through electrode that is connected to the rear-surface wire and that passes through the semiconductor substrate. This provides an effect of drawing a wire from the rear surface side of the semiconductor substrate on which the semiconductor element is formed, to the outside.

Moreover, according to the first aspect, the semiconductor device may further include an insulation film that insulates the rear-surface wire and the through electrode from the semiconductor substrate, and a material of the filling film may be the same as a material of the insulation film. This provides an effect of simultaneously forming the filling film and the insulation film.

Further, according to the first aspect, the semiconductor element may be a back-illuminated solid state imaging element. This provides an effect of drawing a wire from a surface opposite to an imaging region of the solid state imaging element to the outside.

### [Brief Description of Drawings]

[FIG. 1]

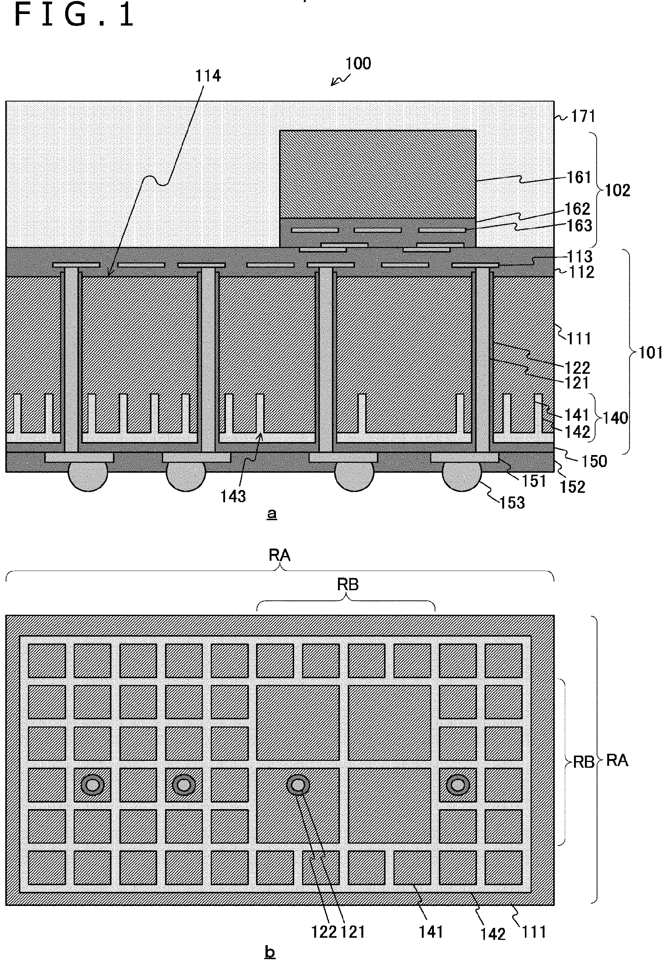

   FIG. 1 depicts cross sections of a configuration example of a semiconductor device according to a first embodiment.
[FIG. 2]

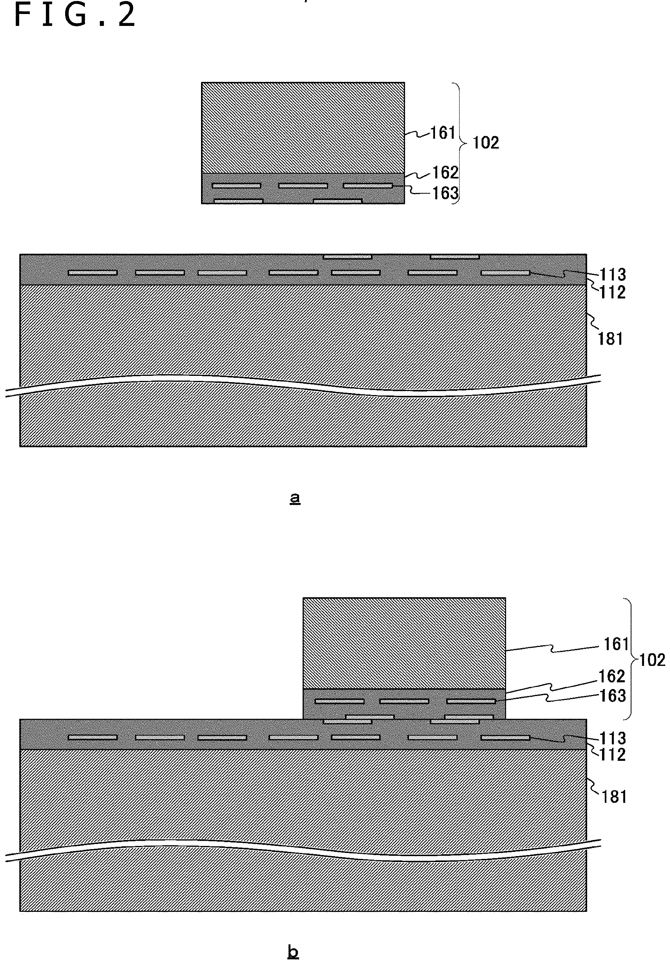

   FIG. 2 depicts first cross sections in one example of a manufacturing method of the semiconductor device according to the first embodiment.
[FIG. 3]

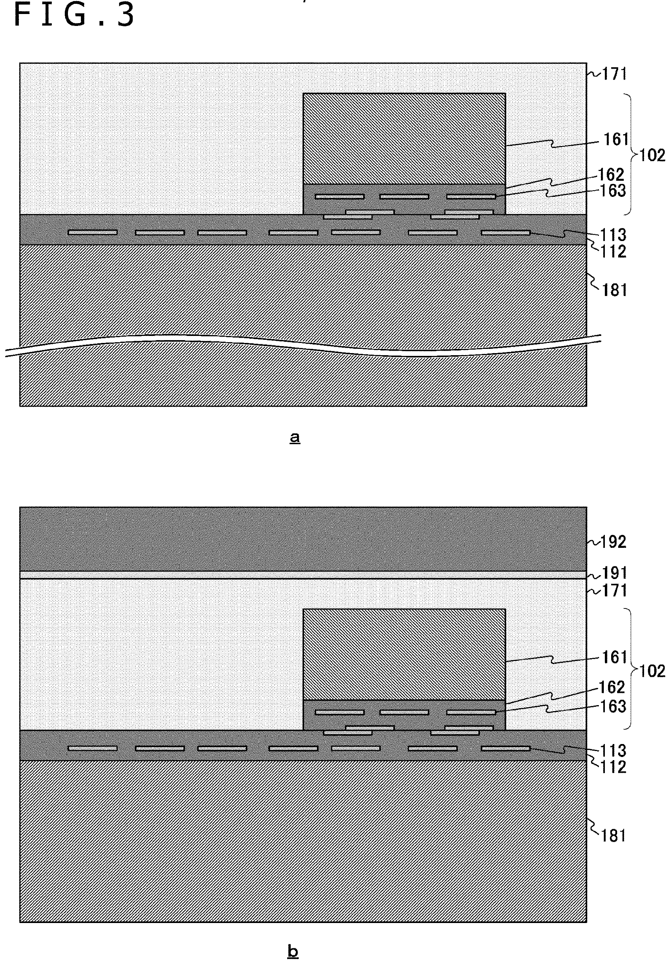

   FIG. 3 depicts second cross sections in the one example of the manufacturing method of the semiconductor device according to the first embodiment.
[FIG. 4]

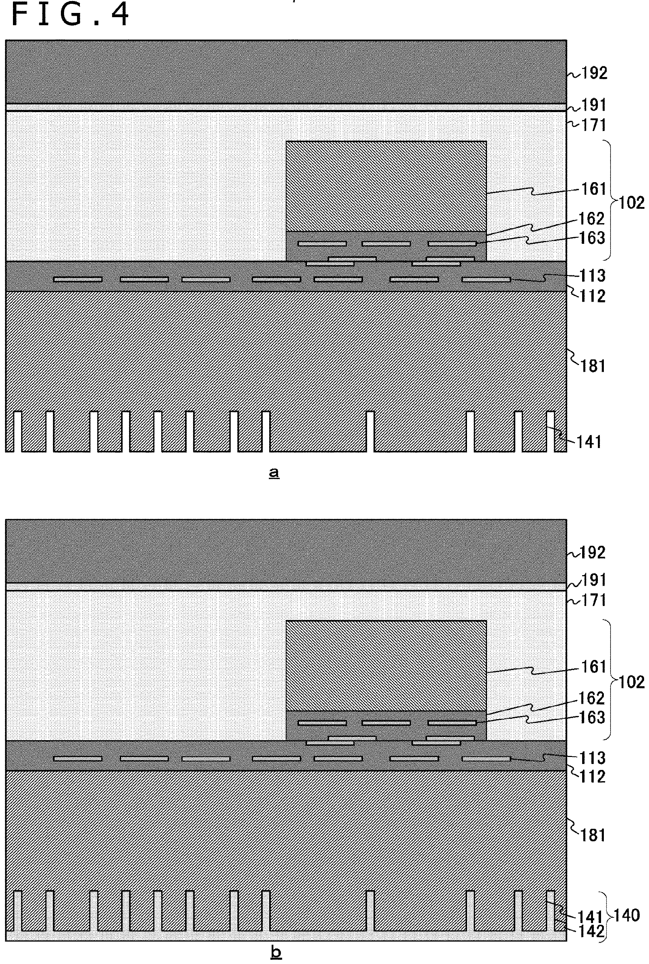

   FIG. 4 depicts third cross sections in the one example of the manufacturing method of the semiconductor device according to the first embodiment.
[FIG. 5]

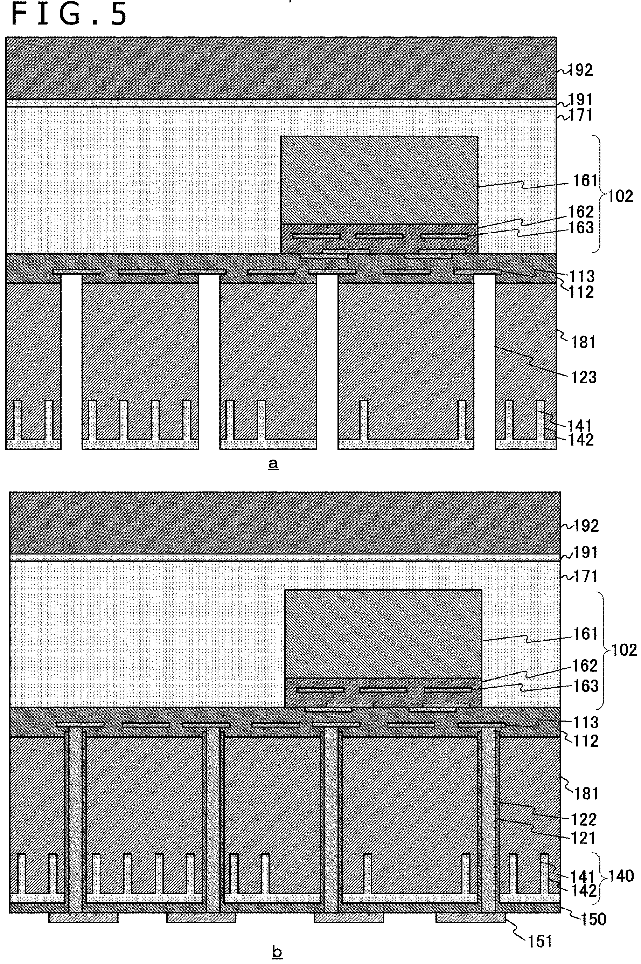

   FIG. 5 depicts fourth cross sections in the one example of the manufacturing method of the semiconductor device according to the first embodiment.
[FIG. 6]

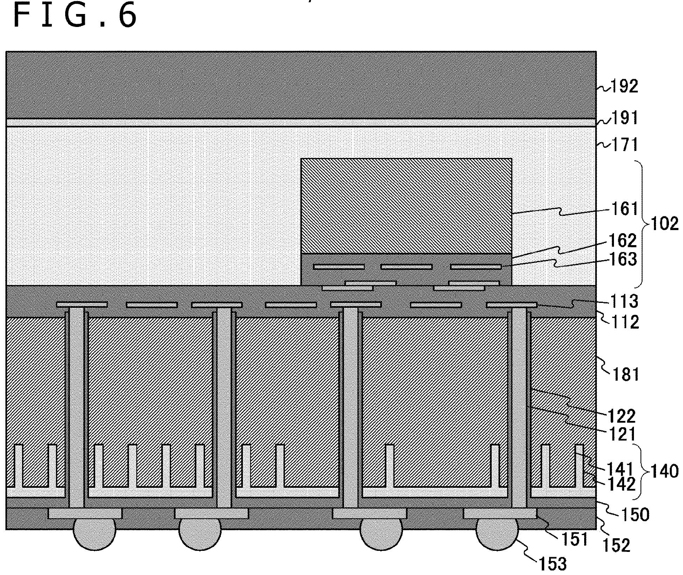

   FIG. 6 depicts a fifth cross section in the one example of the manufacturing method of the semiconductor device according to the first embodiment.
[FIG. 7]

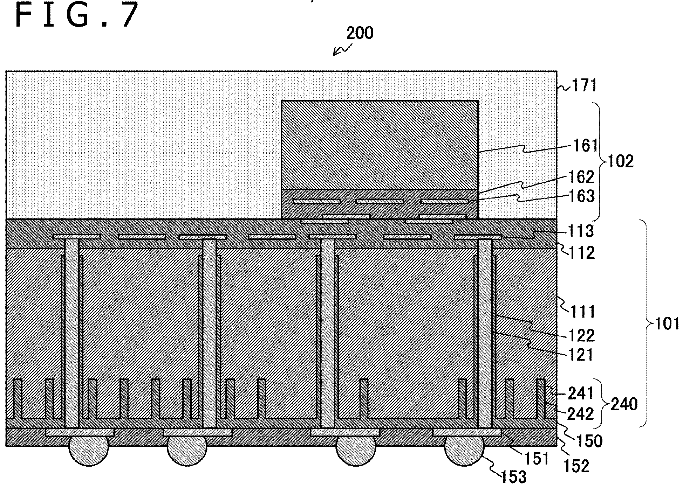

   FIG. 7 depicts a cross section of a configuration example of a semiconductor device according to a second embodiment.
[FIG. 8]

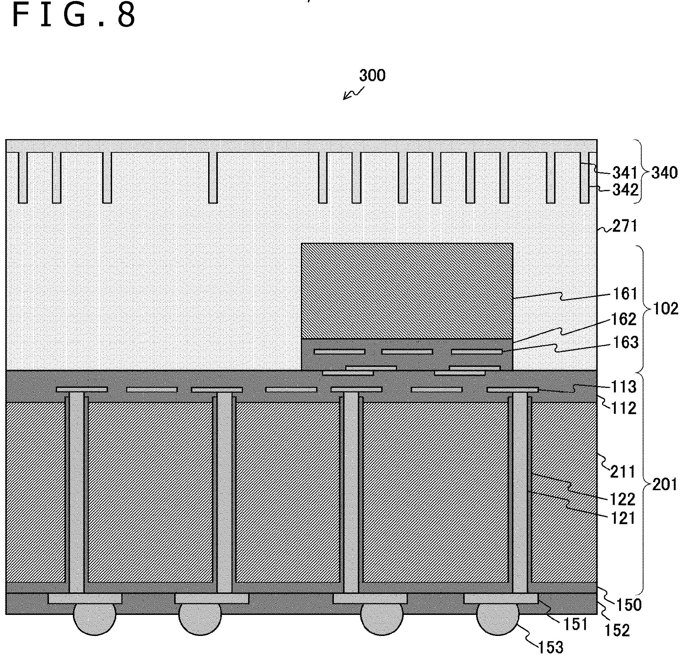

   FIG. 8 depicts a cross section of a configuration example of a semiconductor device according to a third embodiment.
[FIG. 9]

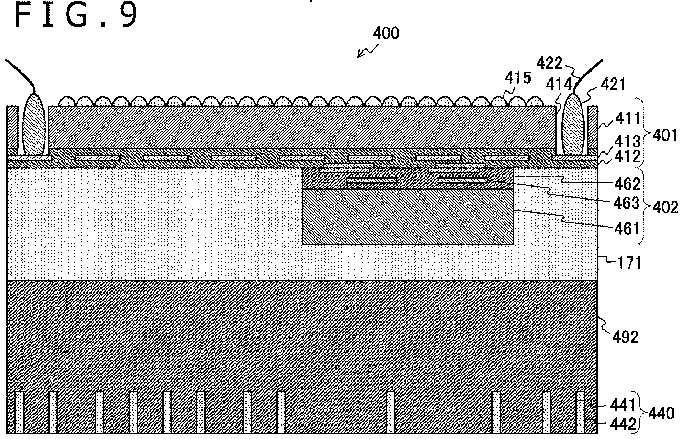

   FIG. 9 depicts a cross section of a configuration example of a semiconductor device according to a fourth embodiment.
[FIG. 10]

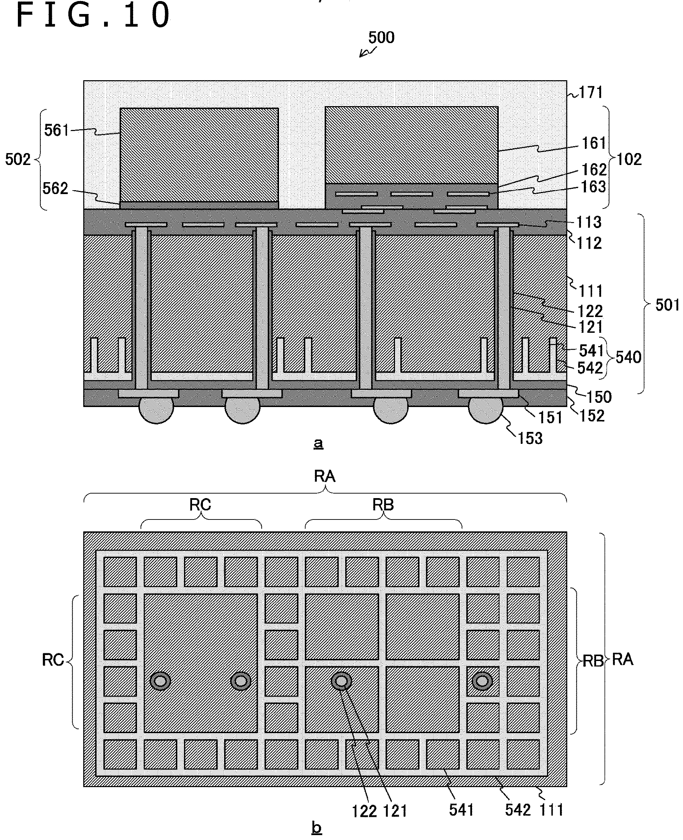

   FIG. 10 depicts cross sections of a configuration example of a semiconductor device according to a fifth embodiment.
[FIG. 11]

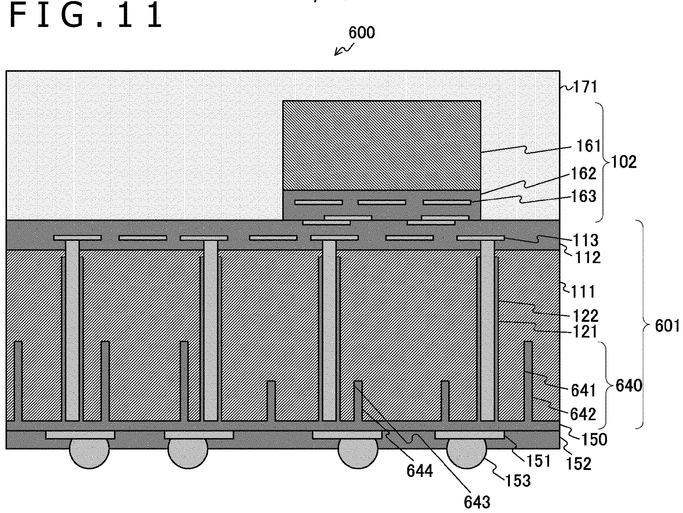

   FIG. 11 depicts a cross section of a configuration example of a semiconductor device according to a sixth embodiment.
[FIG. 12]

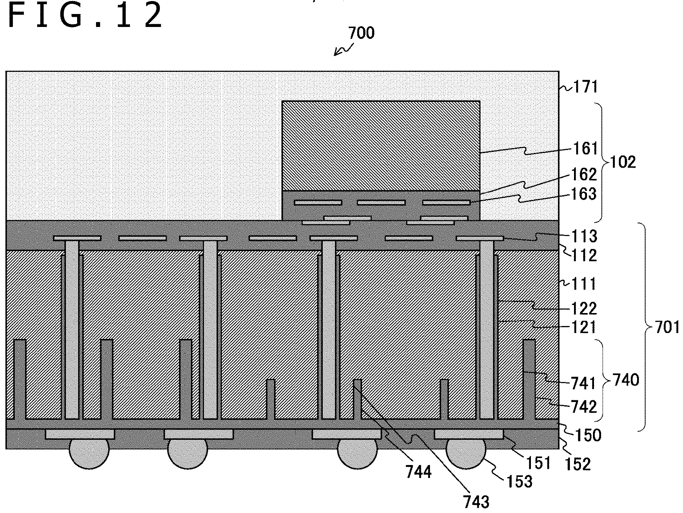

   FIG. 12 depicts a cross section of a configuration example of a semiconductor device according to a seventh embodiment.
[FIG. 13]

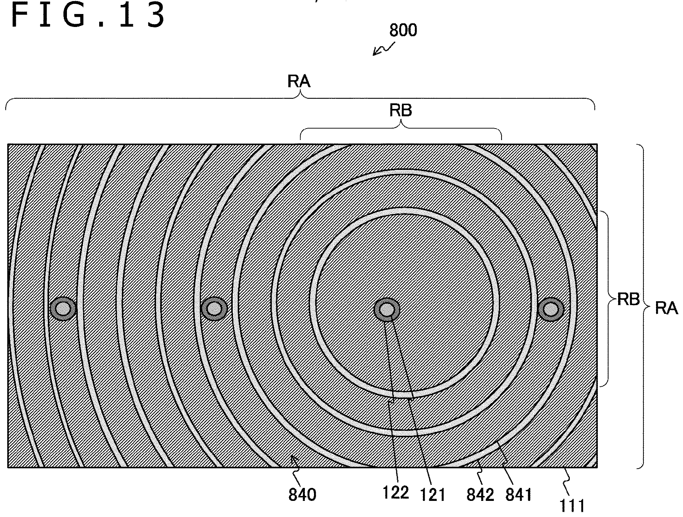

   FIG. 13 depicts a cross section of a configuration example of a semiconductor device according to an eighth embodiment.
[FIG. 14]

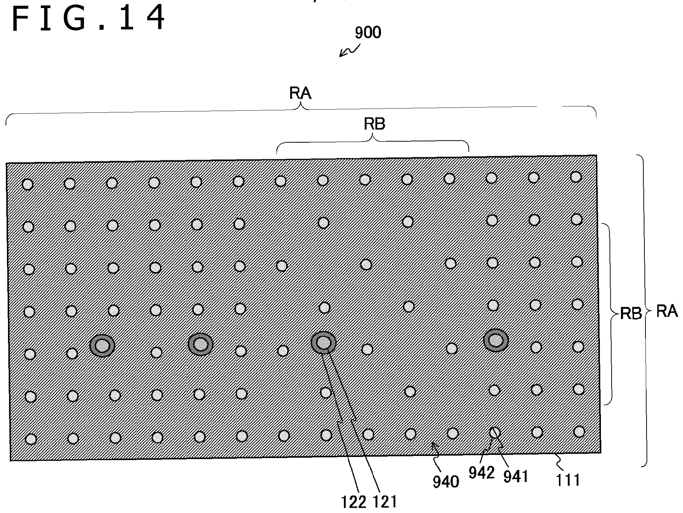

   FIG. 14 depicts a cross section of a configuration example of a semiconductor device according to a ninth embodiment.

### [Description of Embodiments]

Hereinafter, embodiments for carrying out the present technology (hereinafter, referred to as embodiments) will be explained. The explanation will be given according to the following order.
1. First embodiment (in which a recessed portion layer including recessed portions that are unevenly arranged is disposed in a semiconductor substrate)
2. Second embodiment (in which a filling film includes an insulation film for insulating a rear-surface wire from a semiconductor substrate)
3. Third embodiment (in which a recessed portion layer including recessed portions that are unevenly arranged is disposed in a protective film)
4. Fourth embodiment (in which a recessed portion layer including recessed portions that are unevenly arranged is disposed in a support substrate)
5. Fifth embodiment (in which a recessed portion layer including recessed portions the arrangement density of which varies between sub-chips mounted on a semiconductor chip is disposed in a semiconductor substrate)
6. Sixth embodiment (in which recessed portions that are unevenly arranged in a recessed portion layer are different in depth)
7. Seventh embodiment (in which recessed portions that are unevenly arranged in a recessed portion layer are different in depth and width)
8. Eighth embodiment (in which recessed portions that are unevenly arranged in a recessed portion layer each have a circular plan shape)
9. Ninth embodiment (in which recessed portions that are unevenly arranged in a recessed portion layer are formed in an isolated pattern)

### <1. First embodiment>

FIG. 1 depicts cross sections of a configuration example of a semiconductor device according to a first embodiment. It is to be noted that, in FIG. 1, "a" is a cross section of a configuration example of a semiconductor device 100 taken along the vertical direction, while "b" is a cross section of a configuration example of a recessed portion layer 140 taken along the horizontal direction.

In FIG. 1, the semiconductor device 100 includes a semiconductor chip 101 and a sub-chip 102. On the semiconductor chip 101 and the sub-chip 102, for example, a signal processing circuit, a processor such as a CPU (Central Processing Unit), a memory such as a DRAM (Dynamic Random Access Memory), an image sensor, or a combination thereof may be formed. The sub-chip 102 may include a light emitting element such as a light emitting diode or a semiconductor laser, or may include an optical component such as a lens or a prism. The sub-chip 102 is disposed on the semiconductor chip 101. The size of the sub-chip 102 is smaller than the size of the semiconductor chip 101.

The semiconductor chip 101 includes a semiconductor substrate 111 on which a semiconductor element is formed. In this case, the semiconductor substrate 111 includes a formation surface 114 on which the semiconductor element is formed. The formation surface 114 on which the semiconductor element is formed can be disposed on the front surface side of the semiconductor substrate 111, for example. For example, the semiconductor element may be a transistor, a photodiode, a resistor, a capacitor, or a combination thereof. For example, the semiconductor substrate 111 is a single crystal silicon substrate. Alternatively, the semiconductor substrate 111 may be a group III-V substrate of GaAs or the like.

A wiring layer 112 is formed on the semiconductor substrate 111. An insulation layer for insulating wires 113 from each other is disposed in the wiring layer 112. For example, metal such as Al or Cu can be used as the material of the wires 113. For example, SiO₂ can be used as the material of the insulation layer for insulating the wires 113 from each other.

Meanwhile, the sub-chip 102 includes a sub-substrate 161. For example, the sub-substrate 161 is a single crystal silicon substrate. The sub-substrate 161 may be a group III-V substrate of GaAs or the like. A wiring layer 162 is formed on the sub-substrate 161. An insulation layer for insulating wires 163 from each other is disposed in the wiring layer 162. The sub-chip 102 is bonded to a bonding region RB that is disposed within a chip region RA of the semiconductor chip 101. The chip region RA is the region of the entire semiconductor chip 101 in a plan view. For example, the sub-chip 102 can be bonded directly to the semiconductor chip 101 with the wiring layer 112 and the wiring layer 162 opposed to each other. It is to be noted that the wiring layers 112 and 162 may be prepared prior to a semiconductor manufacturing process, or may be redistribution layers (RDL). Micro-bumps may be used to bond the semiconductor chip 101 and the sub-chip 102 together. It is preferable that the thickness of the semiconductor chip 101 and the thickness of the sub-chip 102 each fall within a range of approximately 2 to 200 µm.

On the chip region RA of the semiconductor chip 101, a protective film 171 is formed to cover the sub-chip 102. If the protective film 171 is an inorganic film, SiO₂, SiON, SiN, SiOC, or SiCN can be used as the material of the protective film 171, for example. If the protective film 171 is an organic film, resin having a silicone, polyimide, acrylic, or epoxy skeleton can be used as the material of the protective film 171, for example. Alternatively, the material of the protective film 171 may be a molded resin including a filler of SiO₂, AlN, or the like, or have a layered structure of multiple materials.

Further, a through electrode 121 is embedded in the semiconductor substrate 111 with an insulation film 122 disposed therebetween. The through electrode 121 extends, in the thickness direction, through the semiconductor substrate 111, and is connected to the wire 113. Moreover, on the rear surface side of the semiconductor substrate 111, a rear-surface wire 151 is formed with a rear-surface insulation film 150 disposed therebetween. A protective film 152 is formed on the rear-surface wire 151. For example, metal such as Cu, Ti, Ta, Al, W, Ni, Ru, or Co can be used as materials of the through electrode 121 and the rear-surface wire 151. Alternatively, the through electrode 121 and the rear-surface wire 151 may each have a layered structure of multiple materials. If the insulation film 122 and the rear-surface insulation film 150 are inorganic films, SiO₂, SiON, SiN, SiOC, or SiCN can be used as the materials of the insulation film 122 and the rear-surface insulation film 150, for example. If the insulation film 122 and the rear-surface insulation film 150 are organic films, resin having a silicone, polyimide, acrylic, or epoxy skeleton can be used as the materials of the insulation film 122 and the rear-surface insulation film 150, for example. A solder resist can be used as the material of the protective film 152, for example.

A protruding electrode 153 is connected to the rear-surface wire 151. In this case, from the connection position between the rear-surface wire 151 and the protruding electrode 153, the protective film 152 is removed to expose the rear-surface wire 151 from the protective film 152. The protruding electrode 153 can be used as an external connection terminal for connecting the semiconductor chip 101 to a mother substrate or the like. For example, the protruding electrode 153 may be a ball electrode such as a solder ball, or may be a pillar electrode including a conductive body.

In addition, a recessed portion layer 140 is disposed on the rear surface side of the semiconductor substrate 111. The recessed portion layer 140 includes recessed portions 141 that have openings 143 in the same surface other than the formation surface 114 of the semiconductor element and that are unevenly arranged. Each recessed portion 141 is filled with a filling film 142. For example, the recessed portions 141 may be unevenly arranged in the recessed portion layer 140 so as to reduce warpage of the semiconductor substrate 111, or the recessed portions 141 may be unevenly arranged in the recessed portion layer 140 so as to prevent occurrence of warpage of the semiconductor substrate 111. The recessed portion layer 140 is disposed separately from an element isolation region that is formed in the semiconductor substrate 111 and that isolates the semiconductor element. In this case, a trench to be used in the element isolation region can be disposed on the front surface side of the semiconductor substrate 111. Meanwhile, the openings 143 of the recessed portions 141 are disposed on the rear surface side of the semiconductor substrate 111.

The recessed portions 141 may be grooves, or may be holes. The recessed portions 141 may be formed in a lattice-like pattern, a circular pattern, or an isolated pattern. It is preferable that each of the recessed portions 141 have a width that is greater than 0 µm but is equal to or less than 10 µm and have a depth that is greater than 0 µm but is equal to or less than 30 µm.

The recessed portions 141 may be different in at least one of a density, a width, a depth, and a shape in the recessed portion layer 140. In this case, the recessed portions 141 may be different in at least one of the density, the width, the depth, and the shape in the recessed portion layer 140, according to the position of the sub-chip 102 which is mounted on the semiconductor chip 101. In another case, the recessed portions 141 may be different in at least one of the density, the width, the depth, and the shape in the recessed portion layer 140, according to the wire density of the wires 113 which are formed on the semiconductor substrate 111.

In still another case, the recessed portions 141 may be different in at least one of the density, the width, the depth, and the shape in the recessed portion layer 140, according to the arrangement density of the through electrodes 121 which are formed in the semiconductor substrate 111. In yet another case, the recessed portions 141 may be different in at least one of the density, the width, the depth, and the shape in the recessed portion layer 140, according to a local variation of the substrate thickness of the semiconductor substrate 111. In addition, the recessed portions 141 can be separated from an end of the semiconductor substrate 111. The distance between the recessed portions 141 and an end of the semiconductor substrate 111 can be set to be approximately 10 µm, for example.

Here, the example in which the recessed portions 141 are formed in a lattice-like shape and the density of the recessed portions 141 in the recessed portion layer 140 within the bonding region RB of the sub-chip 102 is lower than the density of the recessed portions 141 in the recessed portion layer 140 within the chip region RA of the semiconductor chip 101 has been explained. Also, the example in which the recessed portions 141 are separated from an end of the chip region RA of the semiconductor chip 101 has been explained. It is to be noted that the density of the recessed portions 141 in the recessed portion layer 140 within the bonding region RB of the sub-chip 102 may be higher than the density of the recessed portions 141 in the recessed portion layer 140 within the chip region RA of the semiconductor chip 101. In this case, the density of the recessed portions 141 in the recessed portion layer 140 within the bonding region RB of the sub-chip 102 can vary according to the direction of warpage of the semiconductor substrate 111.

If the filling film 142 is an inorganic insulation film, SiO₂, SiON, SiN, SiOC, or SiCN can be used as the material of the filling film 142, for example. If the filling film 142 is an organic film, resin having a silicone, polyimide, acrylic, or epoxy skeleton can be used as the material of the filling film 142, for example. Alternatively, if the filling film 142 is a conductive film, metal such as Cu, Ti, Ta, Al, W, Ni, Ru, or Co may be used as the material of the filling film 142, or the filling film 142 may have a layered structure of multiple materials.

FIGS. 2 to 6 each depict a cross section of one example of a manufacturing method for the semiconductor device according to the first embodiment.

As depicted in "a" of FIG. 2, the sub-chip 102 is formed by cutting the sub-substrate 161 on which an unillustrated semiconductor element and the wiring layer 162 are disposed, into a chip-shaped piece. Further, an unillustrated semiconductor element and the wiring layer 112 are formed on a semiconductor wafer 181.

Next, as depicted in "b" of FIG. 2, the sub-chip 102 is bonded directly to the semiconductor wafer 181 in such a manner as to electrically connect the wires 113 in the wiring layer 112 to the wires 163 in the wiring layer 162. This direct bonding may be achieved by plasma activation, for example.

Next, as depicted in "a" of FIG. 3, the protective film 171 is formed on the wiring layer 112 in such a manner as to cover the sub-chip 102 by CVD (Chemical Vapor Deposition), an application method, or the like, for example. It is to be noted that a surface of the protective film 171 may be flattened by CMP (Chemical Mechanical Polishing) or the like, for example.

Next, as depicted in "b" of FIG. 3, a support substrate 192 is bonded to the protective film 171 with an adhesive agent 191. For example, the support substrate 192 is a silicon substrate, or is a glass substrate. Subsequently, the semiconductor wafer 181 is thinned from the rear surface side with a grinder, by CMP, by wet etching, or by plasma etching, for example.

Next, as depicted in "a" of FIG. 4, the recessed portions 141 are formed on the rear surface side of the semiconductor wafer 181 by lithography or dry etching, for example.

Next, as depicted in "b" of FIG. 4, the filling film 142 filling the recessed portions 141 is formed on the rear surface side of the semiconductor wafer 181. PE-CVD (Plasma Enhanced-Chemical Vapor Deposition), PE-PVD (Plasma Enhanced-Physical Vapor Deposition), ALD (Atomic Layer Deposition), or the like can be adopted to form the filling film 142. A lamination method, an application method, or the like may be adopted to form the filling film 142. The recessed portions 141 may be completely closed with the filling film 142, or a void or seam may remain in the recessed portions 141.

Next, as depicted in "a" of FIG. 5, a through hole 123 extending, in the thickness direction, through the semiconductor wafer 181 is formed by lithography or by dry etching, for example. At this step, the through hole 123 can enter the wiring layer 112 and reach the wire 113.

Next, as depicted in "b" of FIG. 5, the through electrode 121 that is embedded in the through hole 123 via the insulation film 122 and the rear-surface wire 151 disposed on the rear surface side of the semiconductor substrate 111 via the rear-surface insulation film 150 are formed by a semi-additive process. At this step, a via-last TSV (Through Silicon Via) technique can be used. It is to be noted that the same material may be used for the insulation film 122 and the rear-surface insulation film 150, and the insulation film 122 and the rear-surface insulation film 150 may be simultaneously formed.

Next, as depicted in FIG. 6, the protective film 152 and the protruding electrode 153 are formed on the rear surface side of the semiconductor wafer 181.

Next, as depicted in FIG. 1, the support substrate 192 and the adhesive agent 191 are removed. Then, the semiconductor wafer 181 is cut into a chip-shaped piece by a dicing process, for example. As a result, the semiconductor chip 101 on which the sub-chip 102 is mounted is formed.

As described so far, in the above-described first embodiment, the recessed portion layer 140 including the recessed portions 141 that have the openings 143 in the same surface other than the formation surface 114 of the semiconductor element and that are unevenly arranged is formed on the rear surface side of the semiconductor substrate 111. Accordingly, uneven warpage of the semiconductor substrate 111, which may be caused by disposition of the sub-chip 102 on the semiconductor chip 101, can be corrected while the occupation area of the semiconductor element that is formed on the front surface side of the semiconductor substrate 111 is not reduced. In this case, a warpage distribution in the semiconductor chip 101 can be freely adjusted. A high warpage correction effect can be achieved for a structure such as a 2.5D or 3D layered structure which has a complicated warpage distribution.

In addition, in the above-described first embodiment, lattice-like grooves are used as the recessed portions 141 in the recessed portion layer 140. Therefore, it is possible to finely adjust the width or the density of the recessed portions 141 without increasing the number of steps. Accordingly, the accuracy of correcting uneven warpage of the semiconductor substrate 111 can be enhanced.

In addition, in the above-described first embodiment, the recessed portions 141 are separated from an end of the semiconductor substrate 111. Accordingly, occurrence of a crack starting from any one of the recessed portions 141 can be suppressed.

In addition, in the above-described first embodiment, the rear-surface wire 151 is disposed on the rear surface side of the semiconductor chip 101, and the through electrode 121 passing through the semiconductor substrate 111 is disposed. Accordingly, it is unnecessary to draw a wire from the front surface side of the semiconductor chip 101 on which the semiconductor element is formed, to the outside. As a result, the occupation area of the semiconductor element that is formed on the front surface side of the semiconductor chip 101 can be increased.

In addition, in the above-described first embodiment, the sub-chip 102 is mounted on the semiconductor wafer 181, and is then cut into a chip-shaped piece by a dicing process or the like. Accordingly, it is unnecessary to arrange the directions and positions of the chip-shaped pieces of the semiconductor chips 101 one by one in order to form the semiconductor chips 101 on which the sub-chips 102 are mounted. As a result, the efficiency of the manufacturing process is increased.

In addition, in the above-described first embodiment, the openings 143 in the unevenly arranged recessed portions 141 are disposed in the same surface other than the formation surface 114 of the semiconductor element. Accordingly, it is possible to unevenly arrange the recessed portions 141 in the recessed portion layer 140 without being affected by a restriction on the arrangement position of the semiconductor element. Further, the recessed portions 141 that are unevenly arranged can be formed by a single lithography process and a single dry etching process. As a result of this, uneven warpage of the semiconductor substrate 111 can be corrected while an increase in the number of steps is suppressed.

### <2. Second embodiment>

In the above-described first embodiment, the recessed portion layer 140 including the recessed portions 141 that are unevenly arranged and are filled with the filling film 142 which is provided separately from the insulation film 122 for insulating the through electrode 121 from the semiconductor substrate 111 is disposed in the semiconductor substrate 111. In a second embodiment, the insulation film 122 or the rear-surface insulation film 150 is used as a filling film 242.

FIG. 7 depicts a cross section of a configuration example of a semiconductor device according to the second embodiment.

In a semiconductor device 200 according to the second embodiment, a recessed portion layer 240 is disposed in place of the recessed portion layer 140 of the semiconductor device 100 according to the above-described first embodiment. The remaining configurations of the semiconductor device 200 according to the second embodiment are identical to those of the semiconductor device 100 according to the above-described first embodiment.

The recessed portion layer 240 includes recessed portions 241 that are unevenly arranged according to warpage of the semiconductor substrate 111. Each recessed portion 241 is filled with the filling film 242. The same material of the insulation film 122 or the same material of the rear-surface insulation film 150 may be used for the filling film 242. In this case, the insulation film 122, the filling film 242, and the rear-surface insulation film 150 can be simultaneously formed. For example, in the above-described first embodiment, each of the recessed portions 141 is filled with the filling film 142 in "b" of FIG. 4, and then, the through hole 123 is formed in the semiconductor wafer 181 in "a" of FIG. 5. In the second embodiment, it is possible that, before each of the recessed portions 241 is filled with the filling film 242, the through hole 123 is formed in the semiconductor wafer 181 and, when the insulation film 122 and the rear-surface insulation film 150 are being formed, each of the recessed portions 241 is filled with the filling film 242.

SiO₂, SiON, SiN, SiOC, or SiCN can be used as the material of the insulation film 122, the filling film 242, and the rear-surface insulation film 150, if an inorganic material is used. Resin having a silicone, polyimide, acrylic, or epoxy skeleton can be used as the material of the insulation film 122, the filling film 242, and the rear-surface insulation film 150, if an organic material is used.

As described so far, the insulation film 122 or the rear-surface insulation film 150 is used as the filling film 242 according to the above-described second embodiment. Accordingly, the filling film 242 is formed during a step of forming the insulation film 122 or the rear-surface insulation film 150, so that the number of steps can be reduced. Specifically, the step depicted in "b" of FIG. 4 in the above-described first embodiment can be omitted.

### <3. Third embodiment>

In the above-described first embodiment, the recessed portion layer 140 including the recessed portions 141 that are unevenly arranged is disposed in the semiconductor substrate 111. In a third embodiment, a recessed portion layer 340 is disposed in the protective film 171.

FIG. 8 depicts a cross section of a configuration example of a semiconductor device according to the third embodiment.

In a semiconductor device 300 according to the third embodiment, a semiconductor chip 201 and a protective film 271 are disposed in place of the semiconductor chip 101 and the protective film 171 of the semiconductor device 100 according to the above-described first embodiment. The remaining configurations of the semiconductor device 200 according to the third embodiment are identical to those of the semiconductor device 100 according to the above-described first embodiment.

In the semiconductor chip 201, a semiconductor substrate 211 is disposed in place of the semiconductor substrate 111 according to the above-described first embodiment. From the semiconductor substrate 211, the recessed portion layer 140 is eliminated. The remaining configurations of the semiconductor chip 201 according to the third embodiment are identical to those of the semiconductor chip 101 according to the above-described first embodiment.

The protective film 271 is obtained by adding the recessed portion layer 340 to the protective film 171 of the above-described first embodiment. The recessed portion layer 340 can be disposed on the front surface side of the protective film 271. The recessed portion layer 340 includes recessed portions 341 that are unevenly arranged according to warpage of the semiconductor substrate 111. The recessed portions 341 may be different in at least one of a density, a width, a depth, and a shape in the recessed portion layer 340. Further, the recessed portions 341 can be separated from an end of the protective film 271. Each of the recessed portions 341 is filled with a filling film 342. The same material of the filling film 142 of the above-described first embodiment may be used for the filling film 342 of the third embodiment. The remaining configurations of the protective film 271 according to the third embodiment are identical to those of the protective film 171 according to the above-described first embodiment.

As described so far, the recessed portion layer 340 is disposed in the protective film 171 in the above-described third embodiment. Accordingly, uneven warpage of the semiconductor substrate 211 can be corrected while the recessed portion layer 140 is not disposed in the semiconductor substrate 211. Thus, the degree of arrangement freedom and the density of the through electrode 121 can be improved.

### <4. Fourth embodiment>

In the above-described first embodiment, the recessed portion layer 140 including the recessed portions 141 that are unevenly arranged is disposed in the semiconductor substrate 111. In a fourth embodiment, a recessed portion layer 440 is disposed in a support substrate 492.

FIG. 9 depicts a cross section of a configuration example of a semiconductor device according to the fourth embodiment.

A semiconductor device 400 includes a semiconductor chip 401, a sub-chip 402, and the support substrate 492. The semiconductor chip 401 includes a back-illuminated solid state imaging element. The back-illuminated solid state imaging element may be a CMOS (Complementary Metal Oxide Semiconductor) image sensor, or may be a CCD (Charge Coupled Device) image sensor.

The semiconductor chip 401 includes a semiconductor substrate 411 on which semiconductor elements are formed. The semiconductor elements include photodiodes and pixel transistors that are arranged in matrix along the row direction and the column direction. A wiring layer 412 is formed on the semiconductor substrate 411. It is preferable that the thickness of the semiconductor substrate 411 range from 3 to 15 µm. Wires 413 and an insulation layer for insulating the wires 413 from each other are disposed in the wiring layer 412.

On the rear surface side of the semiconductor substrate 411, unillustrated color filters for respective pixels are disposed in a pixel region where the pixels are arranged, and on-chip lenses 415 for the respective pixels are arranged on the color filters. In a peripheral portion of the pixel region, an opening portion 414 for connecting an external connection terminal 421 to the wire 413 is formed in the semiconductor substrate 411 and the wiring layer 412. Further, the external connection terminal 421 is connected to the wire 413 via the opening portion 414, and is connected to the outside via a bonding wire 422.

Meanwhile, the sub-chip 402 includes a sub-substrate 461. A wiring layer 462 is formed on the sub-substrate 461. Wires 463 and an insulation layer for insulating the wires 463 from each other are disposed in the wiring layer 462. A processor for controlling a solid state imaging element may be formed on the sub-chip 402. A memory for storing imaging data outputted from the solid state imaging element may be formed on the sub-chip 402. A signal processing circuit for processing imaging data outputted from the solid state imaging element may be formed on the sub-chip 402.

On the semiconductor chip 401, the protective film 171 is formed in such a manner as to cover the sub-chip 402. The support substrate 492 is bonded to the protective film 171. For example, the support substrate 492 is a silicon substrate, or is a glass substrate.

The recessed portion layer 440 is disposed on the front surface side of the support substrate 492. The recessed portion layer 440 includes the recessed portions 441 that are unevenly arranged according to warpage of the semiconductor substrate 411. The recessed portions 441 may be different in at least one of a density, a width, a depth, and a shape in the recessed portion layer 440.

Each recessed portion 441 is filled with a filling film 442. The same material of the filling film 142 of the above-described first embodiment may be used for the filling film 442 of the fourth embodiment.

As described so far, the recessed portion layer 440 is disposed in the support substrate 492 in the fourth embodiment. Accordingly, even in a case where there is a restriction on the thickness of the semiconductor substrate 411, uneven warpage of the semiconductor substrate 411 can be corrected. Thus, deterioration in optical characteristic which may be caused by the warpage can be suppressed while a back-illuminated solid state imaging element is formed on the semiconductor chip 401.

### <5. Fifth embodiment>

In the above-described first embodiment, the arrangement density of the recessed portions 141 varies according to the position of the sub-chip 102 which is mounted on the semiconductor chip 101. In a fifth embodiment, the arrangement density of recessed portions 541 varies between sub-chips 102 and 502 which are mounted on a semiconductor chip 501.

FIG. 10 depicts diagrams depicting a configuration example of a semiconductor device according to the fifth embodiment. It is to be noted that, in FIG. 10, "a" depicts a cross section of a configuration example of a semiconductor device 500 taken along the vertical direction, while "b" depicts a cross section of a configuration example of a recessed portion layer 540 taken along the horizontal direction.

In the semiconductor device 500 according to the fifth embodiment, a semiconductor chip 501 is disposed in place of the semiconductor chip 101 of the above-described first embodiment, and further, the sub-chip 502 is additionally disposed. The remaining configurations of the semiconductor device 500 according to the fifth embodiment are identical to those of the semiconductor device 100 according to the above-described first embodiment.

The sub-chip 502 includes a sub-substrate 561. An insulation layer 562 is formed on the sub-substrate 561. The sub-chip 502 is bonded to a bonding region RC that is provided within a chip region RA of the semiconductor chip 501. In this case, for example, the sub-chip 502 can be bonded directly to the semiconductor chip 101 with the wiring layer 112 and the insulation layer 562 opposed to each other. The sub-chip 502 may be a semiconductor chip on which a semiconductor element is formed, or may be a dummy chip on which no semiconductor element is formed. Multiple sub-chips 502 may be mounted on the semiconductor chip 101.

In the semiconductor chip 501, the recessed portion layer 540 is disposed in place of the recessed portion layer 140 of the above-described first embodiment. The recessed portion layer 540 includes the recessed portions 541 that are unevenly arranged according to warpage of the semiconductor substrate 111. Each recessed portion 541 is filled with a filling film 542. The same material of the filling film 142 of the above-described first embodiment may be used as the material of the filling film 542 of the fifth embodiment.

The recessed portions 541 may be different in at least one of a density, a width, a depth, and a shape in the recessed portion layer 540. In this case, the recessed portions 541 may be different in at least one of the density, the width, the depth, and the shape in the recessed portion layer 540, according to the positions of the sub-chips 102 and 502 which are mounted on the semiconductor chip 501.

FIG. 10 depicts an example in which the recessed portions 541 form a lattice-like shape and the density of the recessed portions 541 in the recessed portion layer 540 within the bonding regions RB and RC of the sub-chips 102 and 502 are lower than the density of the recessed portions 541 in the recessed portion layer 150 within the chip region RA of the semiconductor chip 501. In this case, in the bonding regions RB and RC of the sub-chips 102 and 502, the density of the recessed portions 541 in the recessed portion layer 540 can vary according to the direction of warpage of the semiconductor substrate 111.

As described so far, the arrangement density of the recessed portions 541 varies between the sub-chips 102 and 502 which are mounted on the semiconductor chip 501 in the configuration according to the above-described fifth embodiment. Accordingly, multiple chips of different types can be bonded to the semiconductor chip 101 while uneven warpage of the semiconductor substrate 111 is corrected. Thus, the multi-functionality of the semiconductor device 500 can be improved while upsizing of the chip is suppressed.

It is to be noted that the sub-chip 502 may be mounted on the semiconductor chip 201 in FIG. 8 and, in place of the recessed portion layer 340, the recessed portion layer 540 may be disposed in the protective film 271. In addition, the sub-chip 502 may be mounted on the semiconductor chip 401 in FIG. 9, and, in place of the recessed portion layer 440, the recessed portion layer 540 may be disposed in the support substrate 492.

### <6. Sixth embodiment>

In the above-described first embodiment, the recessed portions 141 in the recessed portion layer 140 have the same depth. In a sixth embodiment, recessed portions 641 in a recessed portion layer 640 have different depths.

FIG. 11 depicts a cross section of a configuration example of a semiconductor device according to the sixth embodiment.

In a semiconductor device 600 according to the sixth embodiment, the recessed portion layer 640 is disposed in place of the recessed portion layer 140 of the semiconductor device 100 according to the above-described first embodiment. The remaining configurations of the semiconductor device 600 according to the sixth embodiment are identical to those of the semiconductor device 100 according to the above-described first embodiment.

The recessed portion layer 640 includes the recessed portions 641 that are unevenly arranged according to warpage of the semiconductor substrate 111. The recessed portions 641 are different in depth in the recessed portion layer 640, according to the arrangement position of the sub-chip 102. The widths of the recessed portions 641 are equal to or less than approximately 10 µm, and the depths of the recessed portions 641 are equal to or less than approximately 30 µm. In order to correct uneven warpage, the depths of the recessed portions 641 in the recessed portion layer 640 can vary by approximately 10%. It is to be noted that the manufacturing variation regarding the depths of the recessed portions 641 is within approximately 1% per die.

The case where two different depths are adopted has been explained here for simplification, but three or more different depths may be adopted. In addition, a method for changing the density of the recessed portions 641 may be additionally performed. Each recessed portion 641 is filled with a filling film 642. The same material of the filling film 142 of the above-described first embodiment may be used as the material of the filling film 642 of the sixth embodiment.

As described so far, the recessed portions 641 are different in depth according to warpage of the semiconductor substrate 111 in the configuration according to the above-described sixth embodiment. Accordingly, compared to a case where the arrangement density of the recessed portions 641 varies according to warpage of the semiconductor substrate 111, the arrangement area ratio of the recessed portions 641 can be made smaller, so that the through electrodes 121 can be highly integrated.

It is to be noted that, in place of the recessed portion layer 340 in FIG. 8, the recessed portion layer 640 may be disposed in the protective film 271. In addition, in place of the recessed portion layer 440 in FIG. 9, the recessed portion layer 640 may be disposed in the support substrate 492.

In addition, in the above-described embodiment, the lattice interval of the lattice pattern in the longitudinal direction of the semiconductor substrate is set to be equal to that in the lateral direction of the semiconductor substrate. However, the lattice interval of the lattice pattern in the longitudinal direction of the semiconductor substrate may be different from that in the lateral direction of the semiconductor substrate.

### <7. Seventh embodiment>

In the above-described first embodiment, the recessed portions 141 in the recessed portion layer 140 have the same depth and width. In a seventh embodiment, recessed portions 741 in a recessed portion layer 740 have different depths and different widths.

FIG. 12 depicts a cross section of a configuration example of a semiconductor device according to the seventh embodiment.

In a semiconductor device 700 according to the seventh embodiment, the recessed portion layer 740 is disposed in place of the recessed portion layer 140 of the semiconductor device 100 according to the above-described first embodiment. The remaining configurations of the semiconductor device 700 according to the seventh embodiment are identical to those of the semiconductor device 100 according to the above-described first embodiment.

The recessed portion layer 740 includes the recessed portions 741 that are unevenly arranged according to warpage of the semiconductor substrate 111. The recessed portions 741 are different in depth and width in the recessed portion layer 740, according to the arrangement position of the sub-chip 102. The widths of the recessed portions 741 are equal to or smaller than approximately 10 µm. The depths of the recessed portions 741 are equal to or smaller than approximately 30 µm. In order to correct uneven warpage, the widths of the recessed portions 741 in the recessed portion layer 740 can vary by approximately 10%. It is to be noted that the manufacturing variation regarding the widths of the recessed portions 741 is within approximately 1% per die.

The case where two different widths are adopted has been explained here for simplification, but three or more different widths may be adopted. In addition, a method for changing the density of the recessed portions 741 may be additionally performed. Each recessed portion 741 is filled with a filling film 742. The same material of the filling film 142 of the above-described first embodiment may be used as the material of the filling film 742 of the seventh embodiment.

As described so far, the recessed portions 741 are different in depth and width according to warpage of the semiconductor substrate 111 in the configuration according to the above-described seventh embodiment. Accordingly, by a micro loading effect during plasma etching of the semiconductor substrate 111, the depth variation can be generated according to the width differences among the recessed portions 741. Therefore, it is unnecessary to repeatedly perform etching for each of the depths of the recessed portions 741 in order to make the depths of the recessed portions 741 of the semiconductor substrate 111 different, and thus, the processes can be simplified.

It is to be noted that, in place of the recessed portion layer 340 in FIG. 8, the recessed portion layer 740 may be disposed in the protective film 271. In addition, in place of the recessed portion layer 440 in FIG. 9, the recessed portion layer 740 may be disposed in the support substrate 492.

### <8. Eighth embodiment>

In the above-described first embodiment, the recessed portions 141 in the recessed portion layer 140 have a lattice-like plan shape. In an eighth embodiment, recessed portions 841 in a recessed portion layer 840 each have a circular plan shape.

FIG. 13 depicts a cross section of a configuration example of a semiconductor device according to the eighth embodiment. It is to be noted that FIG. 13 depicts a horizontal cross section of the recessed portion layer 840.

In a semiconductor device 800 according to the eighth embodiment, the recessed portion layer 840 is disposed in place of the recessed portion layer 140 of the semiconductor device 100 according to the above-described first embodiment. The remaining configurations of the semiconductor device 800 according to the eighth embodiment are identical to those of the semiconductor device 100 according to the above-described first embodiment.

The recessed portion layer 840 includes the recessed portions 841 that are unevenly arranged according to warpage of the semiconductor substrate 111. The recessed portions 841 are different in shape in the recessed portion layer 840 according to the arrangement position of the sub-chip 102. In FIG. 13, a circular pattern in which the recessed portions 841 have respective concentric circular shapes is adopted. The circular pattern may be a circle pattern, may be an arc pattern, or may be a combination thereof. The circular pattern may be an elliptical pattern. Each recessed portion 841 is filled with a filling film 842. The same material of the filling film 142 of the above-described first embodiment may be used as the material of the filling film 842 of the eighth embodiment.

As described so far, the circular pattern is adopted for the shapes of the recessed portions 841 in the recessed portion layer 840 in the above-described eighth embodiment. Accordingly, compared to a case where the linear lattice pattern is adopted, stress concentration can be suppressed, and the crack resistance can be enhanced.

It is to be noted that the circular pattern may have a depth variation, a width variation, or an interval variation according to warpage of the semiconductor substrate 111. In addition, in place of the recessed portion layer 340 in FIG. 8, the recessed portion layer 840 may be disposed in the protective film 271. In addition, in place of the recessed portion layer 440 in FIG. 9, the recessed portion layer 840 may be disposed in the support substrate 492.

### <9. Ninth embodiment>

In the above-described first embodiment, the recessed portions 141 in the recessed portion layer 140 have a lattice-like plan shape. In a ninth embodiment, recessed portions 941 in a recessed portion layer 940 are formed in an isolated pattern.

FIG. 14 depicts a cross section of a configuration example of a semiconductor device according to the ninth embodiment. It is to be noted that FIG. 14 depicts a horizontal cross section of the recessed portion layer 940.

In a semiconductor device 900 according to the ninth embodiment, the recessed portion layer 940 is disposed in place of the recessed portion layer 140 of the semiconductor device 100 according to the above-described first embodiment. The remaining configurations of the semiconductor device 900 according to the ninth embodiment are identical to those of the semiconductor device 100 according to the above-described first embodiment.

The recessed portion layer 940 includes the recessed portions 941 that are unevenly arranged according to warpage of the semiconductor substrate 111. The recessed portions 941 are formed in an isolated pattern. The arrangement density of the recessed portions 941 in the recessed portion layer 940 in the isolated pattern varies according to the arrangement position of the sub-chip 102. Each recessed portion 941 is filled with a filling film 942. The same material of the filling film 142 of the above-described first embodiment may be used as the material of the filling film 942 of the ninth embodiment.

As described so far, the recessed portions 941 in the recessed portion layer 940 are formed in the isolated pattern in the above-described ninth embodiment. Accordingly, compared to a case where the linear lattice pattern is adopted, stress concentration can be suppressed, and the crack resistance can be enhanced.

It is to be noted that the isolated pattern may have a depth variation, a size variation, and an interval variation according to warpage of the semiconductor substrate 111. In addition, in place of the recessed portion layer 340 in FIG. 8, the recessed portion layer 940 may be disposed in the protective film 271. In addition, in place of the recessed portion layer 440 in FIG. 9, the recessed portion layer 940 may be disposed in the support substrate 492.

Further, in the above-described embodiments, it is assumed that uneven warpage of the semiconductor substrate occurs in the case where chips of different sizes are bonded together. In any other embodiments, uneven warpage of the semiconductor substrate occurs due to an extreme bias of the wire density, or due to a local variation of the substrate thickness. For example, uneven warpage of the semiconductor substrate occurs in a case where a wire area ratio on a chip varies by 1.5 or more times. In a certain specific example, uneven warpage of the semiconductor substrate occurs in a case where the wire area ratio in the center portion of a chip is 30% while the wire area ratio in the peripheral portion of the chip is 45%.

In addition, it is to be noted that the above-described embodiments each exemplify one example for embodying the present technology, and the features of the embodiments have a correspondence with the invention-specifying features of the claims. Also, the invention-specifying features of the claims have a correspondence with components, of the embodiments, referred to in the same names. However, the present technology is not limited to the embodiments of the present technology, and can be embodied by various modifications of the embodiments within the scope of the gist of the present technology. Further, the effects described in the present description are just examples, and thus, are not limitative. In addition, any other effect may be provided.

It is to be noted that the present technology can also adopt the following configurations.
(1) A semiconductor device including:
   a semiconductor substrate on which a semiconductor element is formed;
   a recessed portion layer including recessed portions that have openings in the same surface other than a formation surface of the semiconductor element and that are unevenly arranged; and
   a filling film that fills the recessed portions.
(2) The semiconductor device according to (1), in which
   the filling film is an inorganic film or a resin film.
(3) The semiconductor device according to (1) or (2), in which
   the recessed portions are grooves or holes.
(4) The semiconductor device according to any one of (1) to (3), in which
   the recessed portions are different in at least one of a density, a width, a depth, and a shape in the recessed portion layer.
(5) The semiconductor device according to any one of (1) to (4), in which
   the recessed portions are different in at least one of the density, the width, the depth, and the shape in the recessed portion layer, according to at least one of a position of a sub-substrate which is mounted on the semiconductor substrate, a wire density of a wire which is formed in the semiconductor substrate, and an arrangement density of a through electrode which is formed in the semiconductor substrate.
(6) The semiconductor device according to any one of (1) to (5), in which
   the recessed portions are formed in a lattice-like pattern, a circular pattern, or an isolated pattern.
(7) The semiconductor device according to any one of (1) to (6), in which
   the recessed portion layer is formed on a surface of the semiconductor substrate opposite to the surface on which the semiconductor element is formed.
(8) The semiconductor device according to any one of (1) to (7), further including:
   a protective film that is formed on the semiconductor substrate, in which
   the recessed portion layer is formed in the protective film.
(9) The semiconductor device according to any one of (1) to (8), further including:
   a support substrate that supports the semiconductor substrate, in which
   the recessed portion layer is formed in the support substrate.
(10) The semiconductor device according to any one of (1) to (9), in which
   each of the recessed portions has a width that is greater than 0 µm but is equal to or less than 10 µm, and has a depth that is greater than 0 µm but is equal to or less than 30 µm.
(11) The semiconductor device according to any one of (1) to (10), in which
   the recessed portions are separated from an end of the semiconductor substrate.
(12) The semiconductor device according to any one of (1) to (11), further including:
   a rear-surface wire that is formed on the surface of the semiconductor substrate opposite to the surface on which the semiconductor element is formed; and
   the through electrode that is connected to the rear-surface wire and that passes through the semiconductor substrate.
(13) The semiconductor device according to any one of (1) to (12), further including:
   an insulation film that insulates the rear-surface wire from the semiconductor substrate, in which
   a material of the filling film is the same as a material of the insulation film.
(14) The semiconductor device according to any one of (1) to (13), in which
   the semiconductor element is a back-illuminated solid state imaging element.

### [Reference Signs List]

100: Semiconductor device
101: Semiconductor chip
102: Sub-chip
111: Semiconductor substrate
112, 162: Wiring layer
113, 163: Wire
121: Through electrode
122: Insulation film
140: Recessed portion layer
141: Recessed portion
142: Filling film
150: Rear-surface insulation film
151: Rear-surface wire
152, 171: Protective film
153: Protruding electrode
161: Sub-substrate

## Claims

1. A semiconductor device comprising:
a semiconductor substrate on which a semiconductor element is formed;
a recessed portion layer including recessed portions that have openings in a same surface other than a formation surface of the semiconductor element and that are unevenly arranged; and
a filling film that fills the recessed portions.

2. The semiconductor device according to claim 1, wherein
the filling film is an inorganic film or a resin film.

3. The semiconductor device according to claim 1, wherein
the recessed portions are grooves or holes.

4. The semiconductor device according to claim 1, wherein
the recessed portions are different in at least one of a density, a width, a depth, and a shape in the recessed portion layer.

5. The semiconductor device according to claim 1, wherein
the recessed portions are different in at least one of a density, a width, a depth, and a shape in the recessed portion layer, according to at least one of a position of a sub-substrate which is mounted on the semiconductor substrate, a wire density of a wire which is formed in the semiconductor substrate, and an arrangement density of a through electrode which is formed in the semiconductor substrate.

6. The semiconductor device according to claim 1, wherein
the recessed portions are formed in a lattice-like pattern, a circular pattern, or an isolated pattern.

7. The semiconductor device according to claim 1, wherein
the recessed portion layer is formed on a surface of the semiconductor substrate opposite to the surface on which the semiconductor element is formed.

8. The semiconductor device according to claim 1, further comprising:
a protective film that is formed on the semiconductor substrate, wherein
the recessed portion layer is formed in the protective film.

9. The semiconductor device according to claim 1, further comprising:
a support substrate that supports the semiconductor substrate, wherein
the recessed portion layer is formed in the support substrate.

10. The semiconductor device according to claim 1, wherein
each of the recessed portions has a width that is greater than 0 µm but is equal to or less than 10 µm, and has a depth that is greater than 0 µm but is equal to or less than 30 µm.

11. The semiconductor device according to claim 1, wherein
the recessed portions are separated from an end of the semiconductor substrate.

12. The semiconductor device according to claim 1, further comprising:
a rear-surface wire that is formed on a surface of the semiconductor substrate opposite to the surface on which the semiconductor element is formed; and
a through electrode that is connected to the rear-surface wire and that passes through the semiconductor substrate.

13. The semiconductor device according to claim 12, further comprising:
an insulation film that insulates the rear-surface wire from the semiconductor substrate, wherein
a material of the filling film is same as a material of the insulation film.

14. The semiconductor device according to claim 1, wherein
the semiconductor element is a back-illuminated solid state imaging element.
